**Europäisches Patentamt**

**European Patent Office**

**Office européen des brevets**

(19)

(11) Veröffentlichungsnummer: **0 039 509**
A2

(12) # EUROPÄISCHE PATENTANMELDUNG

(21) Anmeldenummer: **81103390.1**

(22) Anmeldetag: **05.05.81**

(51) Int. Cl.³: **H 01 L 29/74,** H 01 L 21/00

(30) Priorität: **06.05.80 DE 3017313**

(43) Veröffentlichungstag der Anmeldung: **11.11.81**
**Patentblatt 81/45**

(84) Benannte Vertragsstaaten: **CH FR GB IT LI NL SE**

(71) Anmelder: **SIEMENS AKTIENGESELLSCHAFT Berlin und München, Postfach 22 02 61,
D-8000 München 22 (DE)**

(72) Erfinder: **Herberg, Helmut, Dr. Dipl.-Phys.,
Kobellstrasse 12, D-8000 München 2 (DE)**

(54) Thyristor mit hoher Blockierspannung und Verfahren zu seiner Herstellung.

(57) Thyristor mit einem scheibenförmigen Mehrschich-ten-Halbleiterkörper, bei dem die P-Basisschicht an der der N-Emitterschicht zugekehrten Grenzfläche eine Zone erhöhten Dotierungsgrades enthält. Diese wird in late-raler Richtung von einer längs des Thyristorrandes ver-laufenden, einen normalen Dotierungsgrad aufweisenden P-Basis-Randzone begrenzt.

EP 0 039 509 A2

SIEMENS AKTIENGESELLSCHAFT
Berlin und München

0039509

Unser Zeichen
VPA 80 P 7 0 5 6 E

## Thyristor mit hoher Blockierspannung und Verfahren zu seiner Herstellung

Die Erfindung bezieht sich auf einen Thyristor nach dem Oberbegriff des Anspruchs 1 und auf ein Verfahren zu seiner Herstellung.

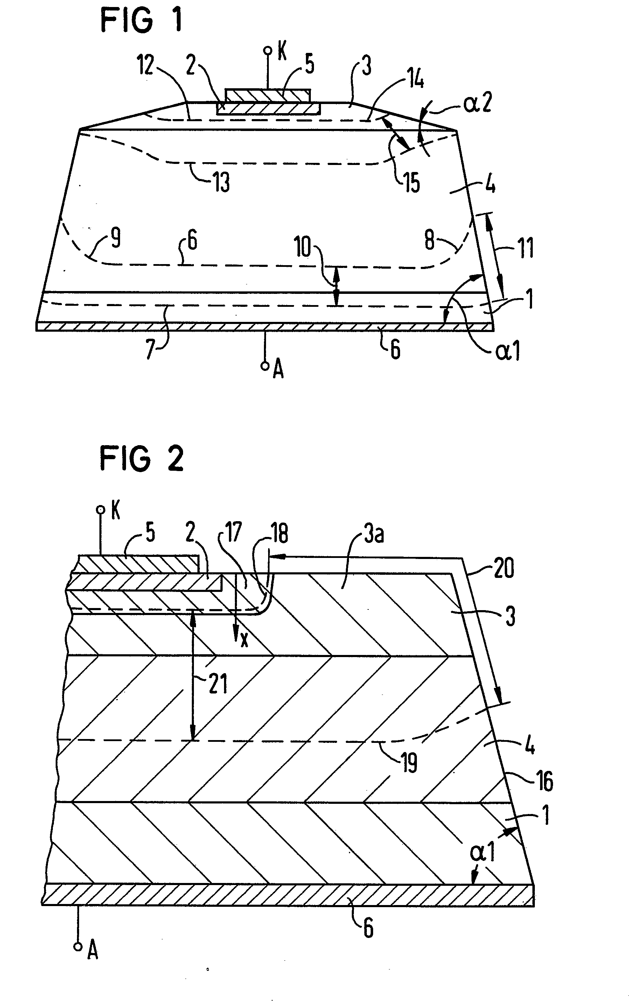

Ein solcher, z. B. aus dem Buch "Thyristor Physics" von Adolph Blicher, Springer Verlag, New York, 1976, Seiten 198 bis 200, insbesondere Figur 14.1 und Figur 14.3, bekannter Thyristor ist in Figur 1 im Querschnitt dargestellt. Dabei sind seine P-Emitterschicht mit 1 bezeichnet, seine N-Emitterschicht mit 2 und seine Basisschichten mit 3 und 4. 3 bedeutet dabei die sogenannte P-Basisschicht, während 4 die N-Basisschicht des Thyristors kennzeichnet. Die N-Emitterschicht 2 ist mit einer Kathode 5 versehen, die einen Anschluß K aufweist, während die P-Emitterschicht 1 mit einer Anode 6 kontaktiert ist, deren Anschluß mit A bezeichnet ist.

Der unter dem Winkel $\alpha 1$ von z. B. 40 bis 60$^\circ$ abgeschrägte Rand der Schichten 1 und 4 führt nun beim Anlegen von Sperrspannungen dazu, daß die durch die gestrichelten Linien 6 und 7 begrenzte Raumladungszone am PN-Übergang zwischen den Schichten 1 und 4 eine randseitige Aufweitung 8, 9 besitzt. Hierdurch ist die im Inneren des Thyristors herrschende, sogenannte Volumenfeldstärke längs des (kürzeren) Doppelpfeils 10 stets größer als die Oberflächenfeldstärke längs des (längeren) Doppelpfeils 11, so daß die Gefahr eines vorzeitigen Oberflächendurchbruches nicht auftritt.

Beim Anlegen einer in Durchlaßrichtung gepolten Spannung

St 1 Kä / 29.4.1980

0039509

an die Anschlüsse A, K ergibt sich im blockierten Zustand des Thyristors eine Raumladungszone 12, 13 am PN-Übergang zwischen den Schichten 3 und 4. Durch eine wesentlich stärkere Abschrägung des Randes der P-Basis 3 unter einem Winkel $\alpha 2$ von etwa 1 bis $4°$ erreicht man zwar auch hier eine randseitige Aufweitung 14 der Raumladungszone 12, 13 mit der damit verbundenen Verringerung der Oberflächenfeldstärke gegenüber der Volumenfeldstärke, doch entsteht in einer geringen Entfernung von dem abgeschrägten Rand der Schicht 3 ein Maximum der Feldstärke längs der Strecke 15, die die kürzeste Verbindung zwischen den Linien 12 und 13 darstellt. Um den durch dieses Maximum verursachten Durchbruch des Thyristors in den Bereich sehr hoher Blockierspannungen zu verlegen, muß der Winkel $\alpha 2$ noch weiter verkleinert werden, was aber einerseits zu fertigungstechnischen Schwierigkeiten führt und andererseits die stromführende Fläche des Thyristors in unzulässiger Weise verringert.

Der Erfindung liegt die Aufgabe zugrunde, einen Thyristor der eingangs genannten Art anzugeben, bei dem die Gefahr eines Durchbruches erst bei sehr hohen Blockierspannungen auftritt. Diese Aufgabe wird durch die im Anspruch 1 gekennzeichneten Merkmale gelöst.

Der mit der Erfindung erzielbare Vorteil besteht insbesondere darin, daß die Erzielung hoher Blockierspannungen mit einfachen fertigungstechnischen Maßnahmen möglich ist. Da die Breite der Randzone der P-Basisschicht, die die Zone erhöhten Dotierungsgrades in lateraler Richtung begrenzt, durch die Abmessungen einer Dotierungsmaske in einfacher Weise wählbar ist, ergibt sich eine einfache Möglichkeit, die maximal zulässige Blockierspannung mit guter Genauigkeit und Reproduzierbarkeit einzustellen.

Die Ansprüche 2 und 3 geben vorteilhafte Weiterbildungen der Erfindung an. Die Ansprüche 4 bis 7 sind auf zweck-

0039509

mäßige Verfahren zur Herstellung eines erfindungsgemäßen Thyristors gerichtet.

Die Erfindung wird nachfolgend anhand der Zeichnung näher erläutert. Dabei zeigt:

Figur 1 den bereits oben beschriebenen Thyristor nach dem Stand der Technik,

Figur 2 den Querschnitt eines erfindungsgemäß ausgebildeten Thyristors,

Figur 3 ein Dotierungsprofil für den Thyristor nach Figur 2 und

Figur 4 eine schematische Darstellung zur Erläuterung einiger Verfahrensschritte bei der Herstellung des Thyristors nach Figur 2.

Der in Figur 2 mit einem Teilquerschnitt dargestellte Thyristor, dessen Halbleiterkörper z. B. aus Si besteht, unterscheidet sich von Figur 1 zunächst dadurch, daß die P-Basisschicht 3 gegenüber den Schichten 1 und 4 keine weitere randseitige Abschrägung aufweist, sondern entsprechend den Schichten 1 und 4 abgeschrägt ist, so daß die laterale Begrenzungsfläche 16 der Schichten 1 und 4 gleichzeitig auch die Schicht 3 begrenzt. Die P-Basisschicht 3 weist eine in Figur 2 enger schraffierte, P-leitende Zone 17 auf, deren Dotierungsgrad höher ist als der Dotierungsgrad des übrigen Teiles von 3. Dabei besitzt die P-Basisschicht 3 eine längs des Thyristorrandes verlaufende Randzone 3a, die die Zone 17 in lateraler Richtung begrenzt. Beim Anlegen einer Blockierspannung, d. h. einer in Durchlaßrichtung gepolten Spannung zwischen A und K, ergibt sich im Bereich des PN-Übergangs zwischen den Schichten 3 und 4 eine Raumladungszone, die durch die gestrichelten Linien 18 und 19 begrenzt ist. Die Oberflächenfeldstärke entlang dem (längeren) Doppelpfeil 20 ist auch hier kleiner als die Volumenfeldstärke entlang dem Doppelpfeil 21, so daß ein vorzeitiger Durch-

0039509

bruch des Thyristors an der Oberfläche vermieden wird. Andererseits besteht auch nicht die Gefahr eines vorzeitigen Durchbruches in der Nähe der Oberfläche wie bei 15 in Figur 1. Dies ist darauf zurückzuführen, daß die Ausdehnung der Raumladungszone bei hohen Blockierspannungen von der einen höheren Dotierungsgrad aufweisenden Zone 17 praktisch gestoppt wird, wie durch die Linie 18 angedeutet ist.

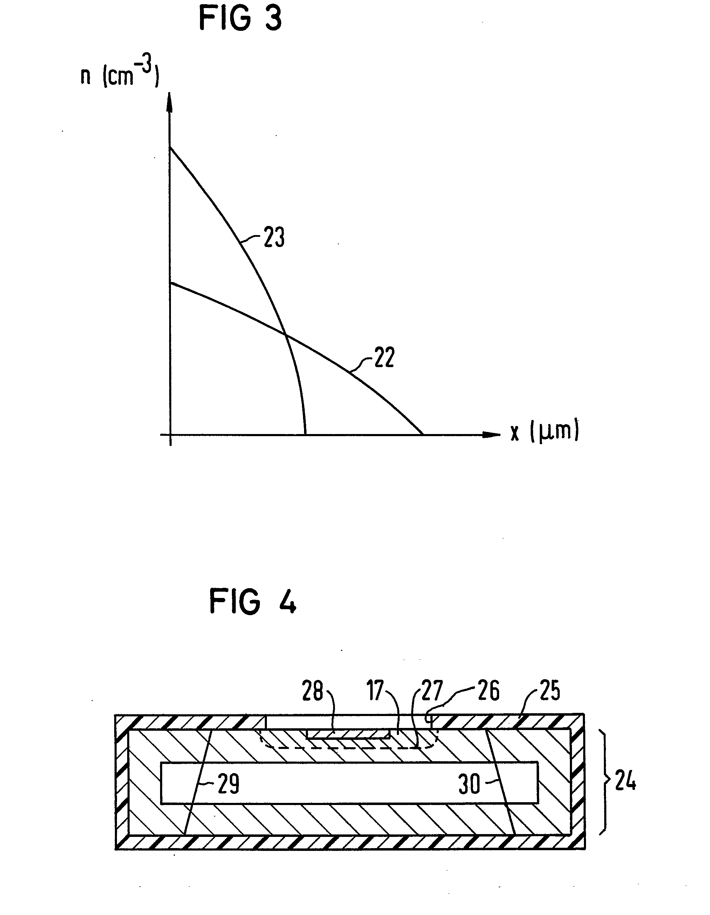

Die inhomogen dotierte P-Basisschicht 3 weist zweckmäßigerweise ein Dotierungsprofil nach Figur 3 auf. Hierbei ist die Dotierungskonzentration n, d. h. die Anzahl der Störstellen pro $cm^3$, in Abhängigkeit von der Eindringtiefe x (Figur 2) aufgetragen. Die Kurve 22 gibt das Dotierungsprofil für einen ersten Dotierungsstoff, z. B. Al, an, der die P-Dotierung der gesamten P-Basisschicht bis zu einer Eindringtiefe von beispielsweise 80 $\mu$m erzeugt. Hinzu kommt das Dotierungsprofil eines zweiten Dotierungsstoffes, z. B. Gallium, welches durch die Kurve 23 gegeben ist. Der zweite Dotierungsstoff wird beispielsweise nur bis zu einer Tiefe von 40 $\mu$m eingebracht, weist aber dafür eine Konzentration an der Oberfläche der Schicht 3 von beispielsweise $10^{18}$ $cm^{-3}$ auf, während die Oberflächenkonzentration des ersten Dotierungsstoffes nur etwa $10^{16}$ $cm^{-3}$ beträgt. Der zweite Dotierungsstoff kann mit Vorteil auch aus Bor bestehen.

Bei der Herstellung des Thyristors nach Figur 2 wird zweckmäßigerweise so vorgegangen, daß in eine N-leitende Halbleiterscheibe 24, insbesondere aus Silizium, zunächst der erste Dotierungsstoff allseitig eingebracht wird, so daß der in Figur 4 schraffierte P-Bereich entsteht. Anschließend wird, z. B. mittels an sich bekannter fotolithografischer Schritte, eine Maske 25 aufgebracht, deren Fenster 26 den Bereich der stärker zu dotierenden Zone 17 definiert. Durch dieses Fenster wird der zweite Dotierungsstoff zunächst oberflächenseitig in der Scheibe 24 deponiert, z. B. im Wege einer Ionenimplantation, und dann so lange eindiffundiert, bis die vorgesehene Eindringtiefe 27 erreicht ist. Besteht der zweite Dotierungsstoff aus Ga, so wählt man zweckmäßigerweise zur Maskierung eine Dreifachschicht aus $SiO_2$, $Si_3N_4$ und $SiO_2$, während bei einer Bor-Diffusion eine $SiO_2$-Maskierung verwendet werden kann. Zur selektiven Einbringung des zweiten Dotierungsstoffes kann anstelle der Fotomaske 25 auch eine mechanische Blende auf der Halbleiterscheibe plaziert werden, die ein Fenster 26 aufweist. Anschließend wird durch einen weiteren, im einzelnen nicht dargestellten Maskierungsschritt die N-Emitterschicht 28 dotiert. Danach wird dann die entlang der Linien 29 und 30 verlaufende Randfläche des Thyristors in an sich bekannter Weise durch Sandstrahlen oder durch einen Läpp- und Ätzvorgang erzeugt und jeweils eine leitende Belegung auf der Schicht 28 und dem unteren Teil der in Figur 4 schraffierten, P-leitenden Schicht aufgebracht, die die Kathode und Anode darstellen. Die Kathode besteht dabei vorzugsweise aus Aluminium, die Anode im allgemeinen aus Molydän.

4 Figuren
8 Patentansprüche

0039509

## Patentansprüche

1. Thyristor mit einem scheibenförmigen Mehrschichten-Halbleiterkörper, der eine außenliegende, mit einer Kathode versehene N-Emitterschicht, eine außenliegende, mit einer Anode versehene P-Emitterschicht und zwei an diese jeweils angrenzende Basisschichten aufweist, bei dem die N-Emitterschicht in ihren lateralen Abmessungen nur einem Teil der angrenzenden P-Basisschicht entspricht, d a - d u r c h   g e k e n n z e i c h n e t , daß die P-Basisschicht (3) an der der N-Emitterschicht (2) zugekehrten Grenzfläche eine Zone (17) enthält, deren Dotierungsgrad höher ist als der Dotierungsgrad des übrigen Teils der P-Basisschicht (3), und daß die P-Basisschicht (3) mit einer die Zone (17) höheren Dotierungsgrades in lateraler Richtung begrenzenden, längs des Thyristorrandes verlaufenden Randzone (3a) versehen ist.

2. Thyristor nach Anspruch 1, d a d u r c h   g e - k e n n z e i c h n e t , daß die laterale Ausdehnung der Zone (17) höheren Dotierungsgrades etwa der der N-Emitterschicht (2) entspricht.

3. Thyristor nach Anspruch 1 oder 2, d a d u r c h g e k e n n z e i c h n e t , daß die gesamte P-Basisschicht (3) einen ersten Dotierungsstoff und die Zone (17) erhöhten Dotierungsgrades zusätzlich einen zweiten Dotierungsstoff enthält, wobei der letztere insbesondere aus Gallium oder Bor besteht.

4. Verfahren zur Herstellung eines Thyristors nach An- spruch 3, d a d u r c h   g e k e n n z e i c h n e t , daß nach einem ganzflächigen Eindringen des ersten Dotierungsstoffes in den Halbleiterkörper (24) der zweite Dotierungsstoff durch eine den lateralen Abmessungen der Zone (17) erhöhten Dotierungsgrades entsprechende Dotie- rungsmaske (25) eingebracht wird.

0039509

5. Verfahren nach Anspruch 4, d a d u r c h g e - k e n n z e i c h n e t , daß als zweiter Dotierungs- stoff Bor verwendet wird und die Dotierungsmaske (25) mittels fotolithografischer Schritte aus einer den Halbleiterkörper (24) bedeckenden Oxidschicht gebildet wird.

6. Verfahren nach Anspruch 4, d a d u r c h g e - k e n n z e i c h n e t , daß als zweiter Dotierungs- stoff Bor verwendet wird und die Dotierung im Wege einer Ionenimplantation durch das Fenster einer mechanischen Blende erfolgt.

7. Verfahren nach Anspruch 4, d a d u r c h g e - k e n n z e i c h n e t , daß als zweiter Dotierungs- stoff Gallium verwendet wird und die Dotierungsmaske (25) mittels fotolithografischer Schritte aus einer den Halbleiterkörper (24) bedeckenden Dreifachschicht aus Siliziumdioxid, Siliziumnitrid und Siliziumdioxid gebildet wird.

8. Verfahren nach Anspruch 4 und einem der Ansprüche 5 oder 7, d a d u r c h g e k e n n z e i c h n e t , daß der zweite Dotierungsstoff im Wege einer Implantation im Halbleiterkörper (24) oberflächenseitig deponiert und anschließend eindiffundiert wird.

0039509

1/2

FIG 1

FIG 2

0039509

2/2

FIG 3

FIG 4